# EUROPEAN PATENT APPLICATION

(11) **EP 0 567 127 A2**
(43) Date of publication of application: **27.10.1993**
(21) Application number: 93106564.3
(22) Date of filing: 22.04.1993
(51) Int. Cl.: H01L 23/528, H01L 27/118

(54) **Semiconductor device capable of correctly forming conductor groups**

(30) Priority: 22.04.1992 JP 102701/92
(71) Applicant: NEC CORPORATION, Tokyo (JP)
(72) Inventor: Kumagai, Kouichi, Minato-ku, Tokyo (JP); Matsubara, Yoshihisa, Minato-ku, Tokyo (JP)
(74) Representative: Glawe, Delfs, Moll & Partner

(57) **Abstract**

In a semiconductor device having circuit cells (15) and first through (N+1)-th insulator layers (19, 29, 39, 51) are successively and consecutively stacked on the circuit cells, where N represents an integer greater than one, first through N-th conductor groups (25, 35, 47) are interposed between adjacent two ones of the insulator layers. Each of the conductor groups comprises conductor lines (27, 37, 49) which are arranged in parallel with a distance left between adjacent two ones of the conductor lines. The distance falls within a range between 0.7 and 20 microns, both inclusive. Each of the insulator layers has via holes (23, 33, 45). Each of the conductor lines is electrically connected to at least one selected from the circuit cells through selected via holes.

## Description

### Background of the Invention:

This invention relates to a semiconductor device having a plurality of insulator layers and a plurality of conductor lines interposed between adjacent two ones of the insulator layers.

In the manner which will later be described more in detail, a conventional semiconductor device comprises a semiconductor substrate, a plurality of circuit cells formed on the semiconductor substrate, first through (N+1)-th insulator layers successively and consecutively stacked on the circuit cells, where N represents an integer greater than one, and first through N-th conductor groups successively and consecutively interposed between adjacent two ones of the first through the (N+1)-th insulator layers.

Each of the first through the N-th conductor groups comprises conductor lines which are arranged in parallel with a distance left between adjacent two ones of the conductor lines. The distance is greater than 20 microns. Each of the conductor lines is electrically connected to at least one selected front the circuit cells.

In a case there the N is greater than 2, recessed portions of N-th upper surface of the N-th insulator layer become deeper. In this case, it is impossible to correctly form the N-th conductor groups on the N-th upper surface.

### Summary of the Invention:

It is therefore an object of the present invention to provide a semiconductor device which is capable of correctly forming conductor groups.

Other objects of this invention will become clear as the description proceeds.

According to this invention, there is provided a semiconductor device which comprises (A) a semiconductor substrate having a principal surface; (B) a plurality of circuit cells formed on the principal surface and having upper cell surfaces; (C) first through (N+1)-th insulator layers successively and consecutively stacked on the upper cell surfaces, where N represents an integer greater than one; (D) first through N-th conductor groups successively and consecutively interposed between adjacent two ones of the first through the (N+1)-th insulator layers, each of the first through the N-th conductor groups comprising conductor lines which are arranged in parallel with a distance left between adjacent two ones of the conductor lines, the distance falling within a range between 0.7 and 20 microns, both inclusive; and the first, (k-1)-th, and k-th insulator layers having first, (k-1)-th, and k-th upper surfaces, respectively, where k is variable between 3 and N, both inclusive, the first insulator layer having first via holes each of which extends between the first upper surface and a selected one of the upper cell surfaces, the k-th insulator layer having k-th via holes each of which extends between the k-th upper surface and a selected one of the conductor lines on the (k-1)-th upper surfaced each of the conductor lines on the first upper surface being connected to at least one selected from the circuit cells through at least one selected from the first via holes, each of the conductor lines on the k-th upper surface being connected to at least one selected from the conductor lines on the (k-1)-th upper surface through at least one selected from the k-th via holes.

### Brief Description of the Drawing:

Fig. 1 is a schematic plan view of a conventional semiconductor device;
Fig. 2 is a schematic sectional view taken along a line 2-2 in Fig. 1;
Fig. 3 is a schematic plan view of a semiconductor device according to a first embodiment of this invention;
Fig. 4 is a schematic sectional view taken along a line 4-4 in Fig. 3;
Fig. 5 is a schematic sectional view taken along a line 5-5 in Fig. 3;
Fig. 6 is a schematic sectional view of a semiconductor device according to a second embodiment of this invention;
Fig. 7 is a schematic sectional view for explaining a method of manufacturing the semiconductor device illustrated in Figs. 1 to 6; and
Fig. 8 is a graph for use in describing operation of the conventional semiconductor device illustrated in Figs. 1 and 2 and the semiconductor device illustrated in Figs. 3 to 6.

### Description of the Preferred Embodiments:

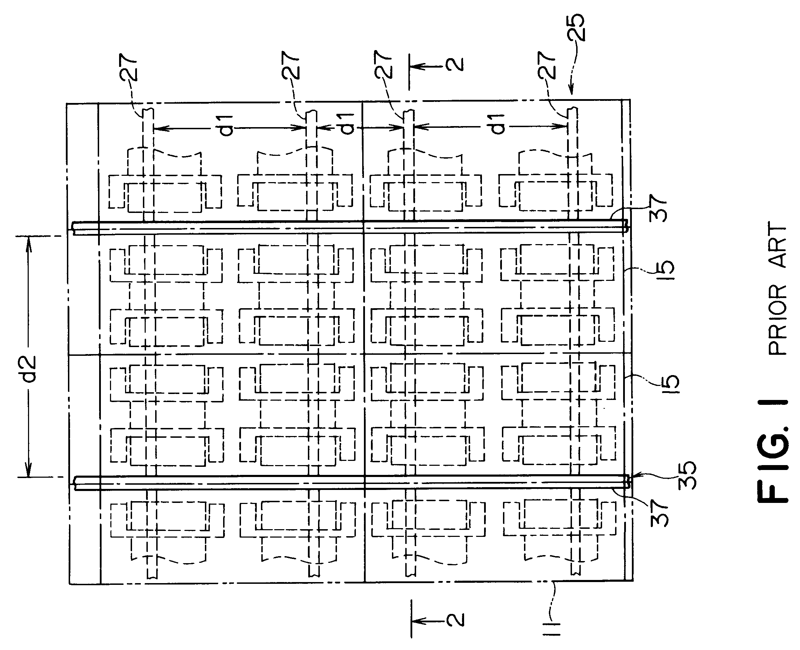

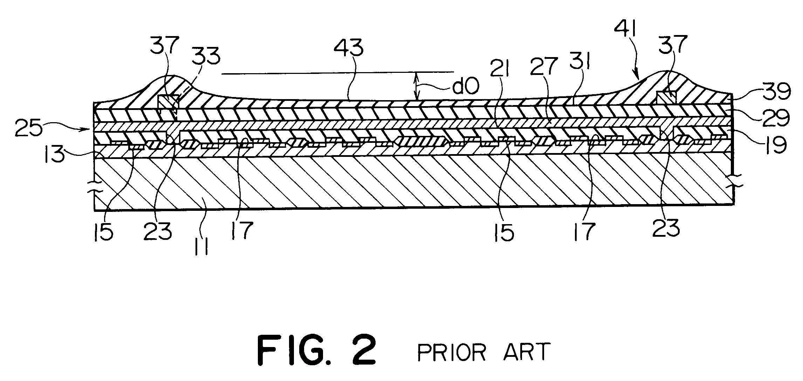

Referring to Figs. 1 and 2, a conventional semiconductor device will first be described for a better understanding of this invention.

In Figs. 1 and 2, the conventional semiconductor device comprises a semiconductor substrate 11 having a principal surface 13. A plurality of circuit cells 15, for example, basic cells or standard cells, are formed on the principal surface 13. The circuit cells 15 have upper cell surfaces 17, respectively. Each of the circuit cells 15 comprises a plurality of circuits. A first insulator layer 19 is stacked on the upper cell surfaces 17. The first insulator layer 19 has a first upper surface 21 and first via holes 23. Each of the first via holes 23 extends between the first upper surface 21 and a selected one of the upper cell surfaces 17.

A first conductor group 25 is formed on the first upper surface 21. The first conductor group 25 comprises conductor lines 27 which are arranged in parallel with a primary distance d1 left between adjacent two ones of the conductor lines 27. The primary distance d1 is greater than 20 microns. Each of the conductor lines 27 is connected to at least one selected from the circuit cells 15 through at least one selected from the first via holes 23.

A second insulator layer 29 overlies the first upper surface 21 and the first conductor group 25. The second insulator layer 29 has a second upper surface 31 and second via holes 33. Each of the second via holes 33 extends between the second upper surface 31 and a selected one of the conductor lines 27.

A second conductor group 35 is formed on the second upper surface 31. The second conductor group 35 comprises conductor lines 37 which are arranged in parallel with a secondary distance d2 left between adjacent two ones of the conductor lines 37. The secondary distance d2 is greater than 20 microns. The conductor lines 37 are rectangular relative to the conductor lines 27. Each of the conductor lines 37 is connected to at least one selected from the conductor lines 27 through at least one selected from the second via holes 33. As a result, each of the conductor lines 37 is electrically connected to at least one selected from the circuit cells 15 through at lest one selected from the conductor lines 27.

A third insulator layer 39 overlies the second upper surface 31 and the second conductor group 35. The third insulator layer 39 has a third upper surface 41 which has recessed portions 43.

The conductor lines 27 and 37 are arranged by using a computer aided design (CAD) system. The conductor lines 27 and 37 are formed by using a photo-lithography method. The greatest value of a deepness d0 of the recessed portions 43 is 3.2 microns. Consequently, it is impossible to make a clear image on the recessed portions 43 of the third upper surface 41 by using the photo-lithography method. As a result, it is impossible to correctly form conductor group on the third upper surface 41.

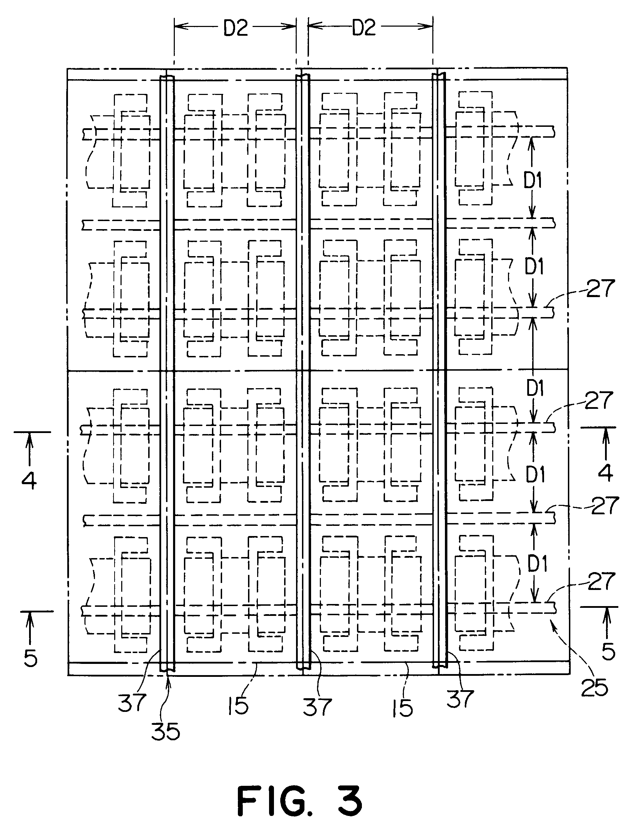

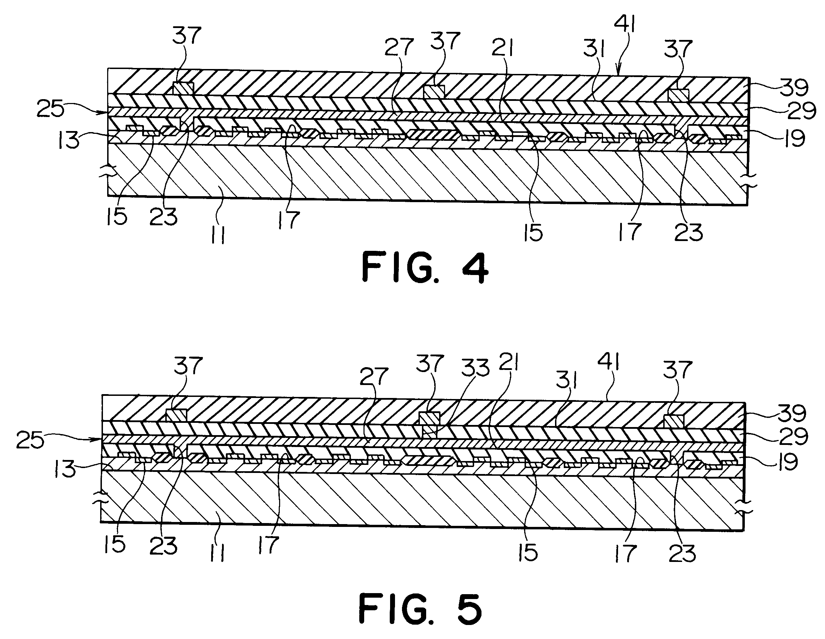

Referring to Figs. 3 to 5, the description will proceed to a semiconductor device according to a first embodiment of this invention. Similar parts are designated by like reference numerals.

The first conductor group 25 comprises the conductor lines 27 which are arranged in parallel with a first distance D1 left between adjacent two ones of the conductor lines 27. The first distance D1 falls within a range between 0.7 and 20 microns, both inclusive.

The second conductor group 35 comprises the conductor lines 37 which are arranged in parallel with a second distance D2 left between adjacent two ones of the conductor lines 37. The second distance D2 falls within a range between 0.7 and 20 microns.

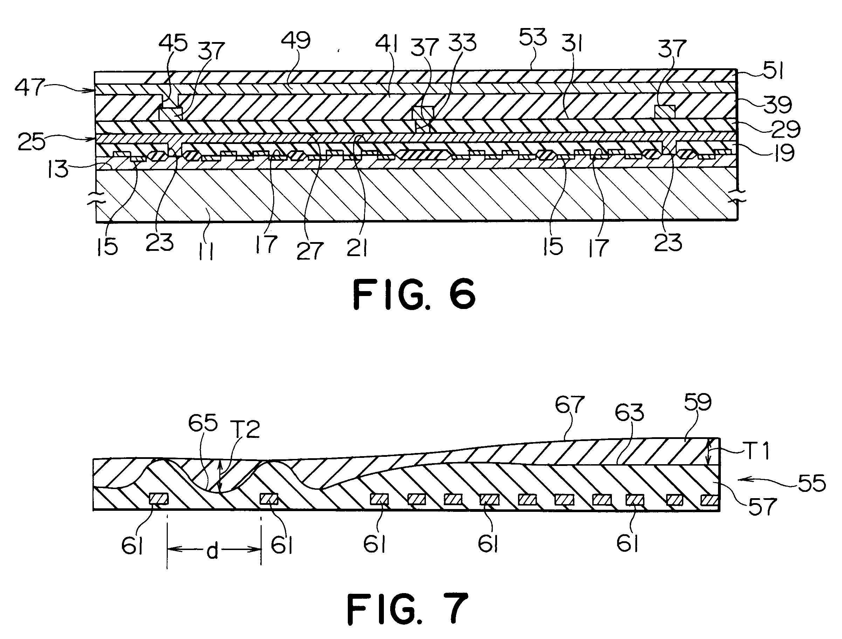

Referring to Fig. 6, the description will proceed to a semiconductor device according to a second embodiment of this invention. Similar parts are designated by like reference numerals.

The third insulator layer 39 has third via holes 45. Each of the third via holes 45 extends between the third upper surface 41 and a selected one of the conductor lines 37.

A third conductor group 47 is formed on the third upper surface 41. The third conductor group 47 comprises conductor lines 49 which are arranged in parallel with a third distance left between adjacent two ones of the conductor lines 49. The third distance falls within a range between 0.7 and 20 microns. The conductor lines 49 are rectangular relative to the conductor lines 37. Each of the conductor lines 49 is connected to at least one selected from the conductor lines 37 through at least one selected from the third via holes 45. As a result, each of the conductor lines 49 is electrically connected to at least once selected from the circuit cells 15 through ones from the conductor lines 37 and 27.

A fourth insulator layer 51 overlies the third upper surface 41 and the third conductor group 47. The fourth insulator layer 51 has a fourth upper surface 53.

In Figs. 3 to 6, the first insulator layer 19 has a thickness of 0.5 to 1.0 microns. The second insulator layer 29 has overlying portions overlying the conductor lines 27 with the remaining portions overlying the first upper surface 21. Each of the overlying portions of the second insulator layer 29 has a thickness of 0.5 to 1.2 microns. Each of the remaining portions of the second insulator layer 29 has a thickness of 1.2 to 2.2 microns.

The third insulator layer 39 has overlying portions overlying the conductor lines 37 with the remaining portions overlying the second upper surface 31. Each of the overlying portions of the third insulator layer 39 has a thickness of 0.5 to 1.2 microns. Each of the remaining portions of the third insulator layer 39 has a thickness of 1.2 to 2.2 microns.

The fourth insulator layer 51 has overlying portions overlying the conductor lines 49 with the remaining portions overlying the third upper surface 41. Each of the overlying portions of the fourth insulator layer 51 has a thickness of 0.5 to 1.2 microns. Each of the remaining portions of the fourth insulator layer 51 has a thickness of 1.2 to 2.2 microns.

Each of the conductor lines 27, 37, and 49 has a thickness of 0.7 to 1.0 microns and a width of 0.7 to 1.5 microns.

Each of the third and the fourth insulator layers 39 and 51 has recessed portions, respectively. The greatest value of a deepness of the recessed portions of the third insulator layer 39 is 1.2 microns. The greatest value of a deepness of the recessed portions of the fourth insulator layer 51 is 1.8 microns. Consequently, it is possible to make a clear image on the third and the fourth upper surfaces 41 and 53 by using the photo-lithography method. As a result, it is possible to correctly form conductor group on the third and the fourth upper surfaces 41 and 53.

Referring to Fig. 7, the description will proceed to an insulator layer 55 of the semiconductor device illustrated in Figs. 1 to 6. The insulator layer 55 is one of the second, the third, and the fourth insulator layers 29, 39, and 51.

The insulator layer 55 comprises a primary layer 57 and a secondary layer 59 formed on the primary layer 57. The primary layer 57 is formed by using a chemical vapor deposition (CVD) method. The secondary layer 59 is formed by using both a spin-on-glass (SOG) method and an etchback method. A plurality of conductor lines 61 are arranged in parallel with a distance d left between the conductor lines 61. The conductor lines 61 are the first, the second, or the third conductor lines 27, 37, or 49.

The primary layer 55 has a flat surface 63 and recessed surfaces 65. The secondary layer 59 has a secondary upper surface 67. The secondary layer 59 has a first thickness T1 between the flat surface 63 and the secondary upper surface 67. The secondary layer 59 has a second thickness T2 between a bottom surface of the recessed surface 65 and the secondary upper surface 67.

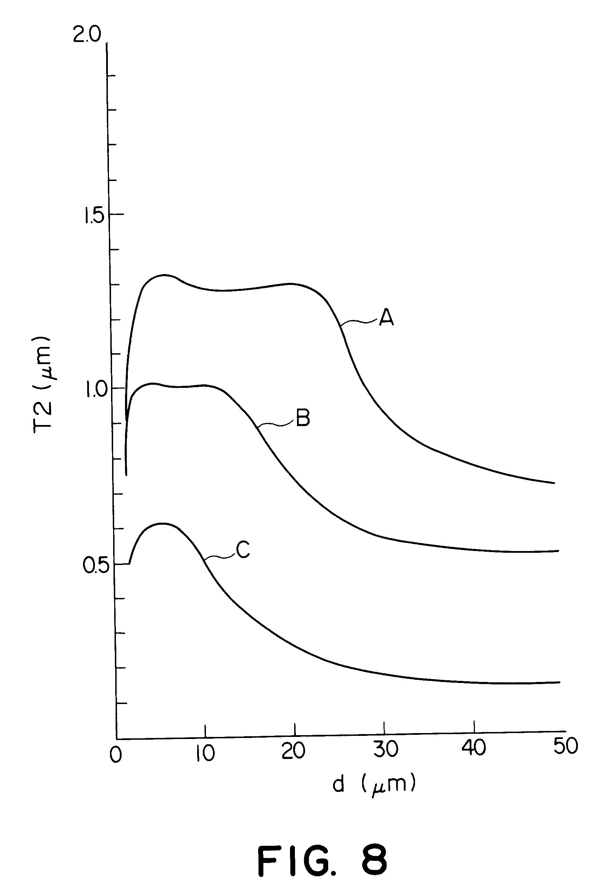

Referring to Fig. 8, a first curved line A exemplifies a relation of the distance d and the second thickness T2 in a case where the first thickness T1 is 0.6 micron. A second curved line B exemplifies a relation of the distance d and the second thickness T2 in a case where the first thickness T1 is 0.4 micron. A third curved line C exemplifies a relation of the distance d and the second thickness T2 in a case where the first thickness T1 is 0.2 micron. As shown by the first, the second, and the third curved lines A, B, and C, the second thickness T2 is large in a case where the distance d falls within a range between 0.7 and 20 microns, both inclusive.

## Claims

1. A semiconductor device comprising:
a semiconductor substrate having a principal surface;
a plurality of circuit cells formed on said principal surface and having upper cell surfaces;
first through (N+1)-th insulator layers successively and consecutively stacked on said upper cell surfaces, where N represents an integer greater than one;
first through N-th conductor groups successively and consecutively interposed between adjacent two ones of said first through said (N+1)-th insulator layers, each of said first through said N-th conductor groups comprising conductor lines which are arranged in parallel with a distance left between adjacent two ones of said conductor lines, said distance falling within a range between 0.7 and 20 microns, both inclusive; and
said first, (k-1)-th, and k-th insulator layers having first, (k-1)-th, and k-th upper surfaces, respectively, where k is variable between 3 and N, both inclusive, said first insulator layer having first via holes each of which extends between said first upper surface and a selected one of said upper cell surfaces, said k-th insulator layer having k-th via holes each of which extends between said k-th upper surface and a selected one of said conductor lines on said (k-1)-th upper surface, each of said conductor lines on said first upper surface being connected to at least one selected from said circuit cells through at least one selected from said first via holes, each of said conductor lines on said k-th upper surface being connected to said at least one selected from said conductor lines on said (k-1)-th upper surface through at least one selected from said k-th via holes.

2. A semiconductor device as claimed in Claim 1, wherein said N is an integer selected from 3 to 5.

3. A semiconductor device as claimed in Claim 1, wherein said first insulator layer has a thickness of 0.5 to 1.0 microns, said k-th insulator layer having overlying portions overlying the conductor lines on said (k-1)-th upper surface with the remaining portions overlying said (k-1)-th upper surface, each of said overlying portions having a thickness of 0.5 to 1.2 microns, each of said remaining portions having a thickness of 1.2 to 2.2 microns, each of said conductor lines having a thickness of 0.7 to 1.0 microns.
